**Europäisches Patentamt**

**European Patent Office**

**Office européen des brevets**

(19)

(11) Veröffentlichungsnummer: **0 133 265 B2**

(12) **NEUE EUROPÄISCHE PATENTSCHRIFT**

(45) Veröffentlichungstag der neuen Patentschrift:
21.08.91 Patentblatt 91/34

(51) Int. Cl.$^5$: **G03F 7/027**

(21) Anmeldenummer: **84108680.4**

(22) Anmeldetag: **23.07.84**

(54) Lichtempfindliches Mehrschichtenmaterial.

(30) Priorität: 30.07.83 DE 3327523

(43) Veröffentlichungstag der Anmeldung:
20.02.85 Patentblatt 85/08

(45) Bekanntmachung des Hinweises auf die
Patenterteilung:
09.12.87 Patentblatt 87/50

(45) Bekanntmachung des Hinweises auf die
Entscheidung über den Einspruch:
21.08.91 Patentblatt 91/34

(84) Benannte Vertragsstaaten:
BE DE FR GB IT

(56) Entgegenhaltungen:
EP-A- 0 064 564
DE-A- 2 062 563
DE-A- 2 902 412
DE-A- 3 236 143
SU-A- 900 244
US-A- 3 754 920
US-A- 4 174 218
US-A- 4 272 608

(56) Entgegenhaltungen:
US-A- 4 323 636
CHEMICAL ABSTRACTS, Band 79, Nr. 8, 27.
August 1973, Seite 369, Nr. 47856e, Columbus,
Ohio, US
ULLMANNS ENCYKLOPÄDIE DER TECHNI-
SCHEN CHEMIE, Band 18, 4. Auflage, Petrolsulfonate bis Plutonium, Verlag Chemie,
Weinheim, DE
CAB-O-SIL, Produktinformation (CABOT Corporation), 1969
Römpps Chemie-Lexikon, 8. Auflage, 1979,
Band 1, S. 79
Handbook of Fillers and Reinforcements for
Plastics, 1978, Kapitel 8, S. 137-140
Angewandte Chemie, Band 72, Jahrg. 1960, S.
744-750
HDK, Pyrogene hochdispersive Kieselsäure,
Wacker Chemie, September 1975
AEROSIL, Degussa, April 1976

(73) Patentinhaber: BASF Aktiengesellschaft
Carl-Bosch-Strasse 38
W-6700 Ludwigshafen (DE)

(72) Erfinder: Jaeckel, Klaus-Peter, Dr.
Uhlandweg 13
W-7602 Oberkirch (DE)

EP 0 133 265 B2

## Beschreibung

Die Erfindung betrifft ein lichtempfindliches Mehrschichtenmaterial, insbesondere zur Herstellung von photopolymeren, flexographischen Druckplatten, mit einer auf einem dimensionsstabilen Träger (T) haftfest aufgebrachten, photopolymerisierbaren, reliefbildenden Schicht (RS) aus einer Mischung von einem elastomeren Nitrilkautschuk, damit verträglichen, photopolymerisierbaren, olefinisch ungesättigten, niedermolekularen Verbindungen, mindestens einem Photopolymerisationsinitiator sowie sonstigen Hilfs- und/oder Zusatzstoffen. Auf der photopolymerisierbaren, reliefbildenden Schicht (RS) kann gegebenenfalls noch eine Deck- oder Schutzschicht (D) aufgebracht sein, die abziehbar oder in dem Entwicklerlösungsmittel für die photopolymerisierbare reliefbildende Schicht (RS) löslich ist.

Lichtempfindliche Mehrschichtenmaterialien zur Herstellung von ölfarbenresistenten, photopolymeren Flexodruckplatten sind bekannt. Die photopolymerisierbare Schicht dieser Mehrschichtenmaterialien enthält im allgemeinen ein elastomeres, kautschukartiges Polymeres als Bindemittel, ein oder mehrere ethylenisch ungesättigte Monomere sowie einen Photoinitiator. In der CA-PS 614 181, der GB-PS 1 358 062, der DE-OS 20 62 563 sowie der DE-OS 29 02 412 werden beispielsweise photopolymerisierbare Mischungen für die Herstellung von Flexodruckplatten beschrieben, die als elastomeres, polymeres Bindemittel Nitrilkautschuke, insbesondere Butadien-Acrylnitril-Copolymerisate, enthalten. Diese photopolymerisierbaren Mischungen können weitere Zusatzstoffe, wie beispielsweise Weichmacher, Farbstoffe, Inhibitoren, Füllstoffe oder Verstärkungsmittel enthalten, wobei in der DE-OS 20 62 563 und der DE-OS 29 02 412 als Füllstoffe beispielsweise Glaspulver, Bentonite, Kirselerde, organophile Kieselerden und Erdalkalistearate genannt sind. Diese Füllstoffe können gemäß der DE-OS 29 02 412 dazu beitragen, die Festigkeit der aus diesen photopolymerisierbaren Mischungen hergestellten elastomeren, lichtempfindlichen Schichten zu verbessern und ihre Klebrigkeit zu verringern.

Ein entscheidender Nachteil der bekannten Mehrschichtenmaterialien für die Herstellung von Flexodruckplatten, deren lichtempfindliche Schicht aus photopolymerisierbaren Mischungen der in Rede stehenden Art gebildet wird, liegt in der großen Neigung zum kalten Fluß dieser photopolymerisierbaren Schichten. Beim Lagern dieser Mehrschichtenmaterialien laufen die photopolymerisierbaren Schichten aus und verkleben häufig in Stapeln übereinander gelagerte Platten. Darüber hinaus kann auch die Dickentoleranz der Mehrschichtenmaterialien, ein wichtiges Kriterium für Druckplatten, durch das Auslaufen der photopolymerisierbaren Schicht beeinträchtigt werden, so daß die Platten gegebenenfalls unbrauchbar werden. Auch durch Einarbeiten der in der Literatur genannten Füllstoffe kann das Problem des kalten Flusses und Auslaufens der photopolymerisierbaren Schichten nicht zufriedenstellend gelöst werden.

In der DE-PS 2 345 120 wird ein lichthärtbares Aufzeichnungsmaterial beschrieben, das zwischen zwei flexiblen Schichtträgern eine feste, fließfähige, lichthärtbare Schicht aufweist, deren Ränder durch Belichten gehärtet worden sind. Hierdurch wird zwar ein Auslaufen des Sandwiches verhindert. Diese Methode benötigt jedoch im Produktionsbereich einen zusätzlichen, kostenintensiven Arbeitsschritt. Darüberhinaus macht dieses Verfahren beim Schneiden der Druckplatten auf kleinere Formate eine neuerliche Randbelichtung notwendig, wodurch Arbeitszeit- und Materialverluste entstehen.

Außerdem ist aus der US-A-4 272 608, insbesondere deren Beispiele 29 bis 31, ein lichtempfindliches Mehrschichtenmaterial bekannt, dessen photopolymerisierbare reliefbildende Schicht (RS) nach der bildmäßigen Belichtung mit aktinischem Licht mit Wasser oder wäßrig-alkalischen Lösungen entwickelt werden kann und als elastomeres Copolymer (Nitrilkautschuk, Bindemittel) den carboxylgruppenhaltigen hochmolekularen Nitrilkautschuk Hycar® 1072 - Dusted Crumb enthält. Dieser carboxylgruppenhaltige hochmolekulare Nitrilkautschuk der Firma B.F. Goodrich Company ist zur besseren Verarbeitbarkeit mit 3 Gew.-% Cab-o-Sil® M-5, einer pyrogenen Kieselsäure der Firma Cabot Corporation, gepudert worden. Zudem sind die Carboxylgruppen dieses hochmolekularen Nitrilkautschuks mit beträchtlichen Mengen an Zinkacetylacetonat umgesetzt worden. Daneben enthalten diese bekannten photopolymerisierbaren reliefbildenden Schichten (RS) wechselnde Mengen niedermolekularer Nitrilkautschuke.

Nachteilig für diese bekannten photopolymerisierbaren reliefbildenden Schichten (RS) und die bekannten lichtempfindlichen Mehrschichtenmaterialien, welche sie enthalten, ist, daß sie nach der bildmäßigen Belichtung mit aktinischem Licht und der Entwicklung flexographische Druckplatten liefern, deren Reliefschicht leicht trübe ist (vgl. die US-A-4 272 608, Spalte 23, Zeilen 53 bis 56). Solche Trübungen, welche auf die Unverträglichkeit zweier oder mehrerer Komponenten der bekannten photopolymerisierbaren reliefbildendn Schichten (RS) zurückzuführen sind, müssen indes von vornherein vermieden werden, wenn man mit Hilfe der betreffenden lichtempfindlichen Mehrschichtenmaterialien feine Details von Motiven reproduzieren will (vgl. die US-A-4 272 608, Spalte 7, Zeile 52, bis Spalte 8, Zeile 6).

Wie aus der US-A-4 272 608 weiter hervorgeht, treten solche nachteiligen Trübungen bei Verwendung eines Vinylchlorid/Vinylacetat-Copolymerisatstaubes in einer Menge, welche die Menge der pyrogenen Kieselsäure immerhin um das 5-fache übersteigt, nicht mehr auf. Indes können Vinylchloridpolymerisate nachgewiesenermaßen das Auslaufen photopolymerisierbarer reliefbildender Schichten (RS) der hier in Rede stehenden Art nicht verhindern.

Aufgabe der vorliegenden Erfindung war es, ein lichtempfindliches Aufzeichnungsmaterial, insbesondere für die Herstellung von ölfarbenresistenten Flexodruckplatten, mit einer photopolymerisierbaren Schicht auf Basis von carboxylgruppenfreien Nitrilkautschuken aufzuzeigen, bei dem die Neigung der photopolymerisierbaren Schicht zum kalten Fluß und zum Auslaufen deutlich verringert ist, so daß hierdurch keine Beeinträchtigungen, zumindest nicht in nennenswertem Umfang, bei der Handhabung und dem Gebrauch der Mehrschichtenmaterialien auftreten und diese auch über längere Zeiträume hinweg in Stapeln übereinander gelagert werden können, ohne daß andere Eigenschaften der Mehrschichtenmaterialien oder der daraus hergestellten Druckplatten, wie z.B. Elastizität, Reißfestigkeit, Härte, Belichtungseigenschaften, Druckeigenschaften etc., verschlechtert oder nachteilig beeinflußt werden.

Diese Aufgabe wird erfindungsgemäß durch lichtempfindliche Mehrschichtenmaterialien mit einer photopolymerisierbaren Schicht auf Basis von carboxylgruppenfreien Nitrilkautschuken gelöst, die in der photopolymerisierbaren Schicht 1 bis 10 Gew.-%, bezogen auf diese Schicht, einer pyrogenen, nachfolgend näher charakterisierten Kieselsäure enthalten.

Gegenstand der Erfindung ist demzufolge ein lichtempfindliches Mehrschichtenmaterial, insbesondere zur Herstellung von flexographischen Druckplatten, mit einer auf einem dimensionsstabilen Träger (T) haftfest aufgebrachten, photopolymerisierbaren, reliefbildenden Schicht (RS), enthaltend mindestens einen Nitrilkautschuk, mindestens eine mit dem Nitrilkautschuk verträgliche photopolymerisierbare niedermolekulare Verbindung und sonstige Hilfs- und/oder Zusatzstoffe, sowie gegebenenfalls mit einer Deck- oder Schutzschicht (D) für die photopolymerisierbare reliefbildende Schicht (RS), wobei die photopolymerisierbare reliefbildende Schicht (RS), bezogen auf die Summe von (a) + (b),

(a) 55 bis 95 Gew.-% eines elastomeren Copolymerisats (Nitrilkautschuk) eines Molekulargewichts von 15.000 bis 150.000 aus, bezogen auf das Copolymerisat, mindestens 50 Gew.-% eines aliphatischen konjugierten Diens mit 4 bis 6 C-Atomen und 15 bis 45 Gew.-% Acrylnitril und/oder eines α-substituierten Acrylnitril-Derivats, wobei carboxylgruppenhaltige Comonomere ausgenommen sind, und

(b) 5 bis 45 Gew.-% mindestens einer mit dem elastomeren Copolymerisat (a) verträglichen niedermolekularen Verbindung mit mindestens zwei photopolymerisierbaren olefinisch ungesättigten Doppelbindungen oder Mischungen hiervon mit monoolefinisch ungesättigten photopolymerisierbaren niedermolekularen Verbindungen sowie, bezogen auf die photopolymerisierbare reliefbildende Schicht (RS),

(c) 0,01 bis 10 Gew.-% eines Photopolymerisationsinitiators,

(d) 1 bis 10 Gew.-% einer pyrogenen Kieselsäure mit einem $SiO_2$-Gehalt von größer als 90 Gew.-%, bezogen auf die pyrogene Kieselsäure, einer Oberfläche nach BET (Brunauer-Emmet-Teller) von 50 bis 400 $m^2/g$ und einer mittleren Primärteilchengröße von 5 bis 50 nm,

0,001 bis 2 Gew.-% mindestens eines thermischen Polymerisationsinhibitors und

bis zu 35 Gew.-% mindestens eines mit dem elastomeren Copolymerisat (a) verträglichen Weichmachers

miteinander kombiniert enthält.

Es hat sich überraschenderweise gezeigt, daß man im Gegensatz zu den in der Literatur beschriebenen Füllstoffen bei Zusatz der speziellen pyrogenen Kieselsäure in photopolymerisierbare Mischungen auf Basis von Nitrilkautschuken zu lichtempfindlichen Mehrschichtenmaterialien gelangt, die selbst nach einer Lagerung im unbelichteten Zustand von mehr als 3 Monaten, z.T. bei erhöhter Temperatur, nicht zum Auslaufen und Verkleben neigen. Setzt man keine pyrogene, sondern beispielsweise gefällte Kieselsäure ein, so erhält man lichtempfindliche Aufzeichnungsmaterialien, deren photopolymerisierbare Schicht nur eine geringe mechanische Festigkeit aufweist. Der kalte Fluß der photopolymerisierbaren Schicht kann in diesen Fällen nur durch wesentlich größere Beimengungen von deutlich mehr als 10 Gew.% nachhaltig verringert werden, wodurch starke Trübungen in der Schicht auftreten, die die Belichtungseigenschaften der Mehrschichtenmaterialien beeinträchtigen. Auch andere bekannte Füllstoffe, wie Talkum, Calciumcarbonat, Calciumstearat oder Polyvinylchlorid-Pulver sind ungeeignet, da sie nicht nur den kalten Fluß nicht im hinreichenden Maße verringern, sondern hierdurch auch andere Eigenschaften der Mehrschichtenmaterialien bzw. der daraus hergestellten Druckplatten, insbesondere die Ausbildung einer fehlerfreien und vorlagengetreuen Reliefstruktur, nachteilig beeinflußt werden. Demgegenüber werden die mechanischen Eigenschaften der aus den erfindungsgemäßen lichtempfindlichen Mehrschichtenmaterialien hergestellten Druckformen durch die Zumengung der pyrogenen Kieselsäure in dem angegebenen Mengenbereich nicht in nennenswertem Maße beeinträchtigt. Vielmehr zeigen die hieraus hergestellten Druckplatten etwa die gleiche Härte und gleichen Druckeigenschaften wie solche ohne Füllstoffe, ihre Elastizität und Reißfestigkeit sind demgegenüber jedoch überraschenderweise gesteigert. Auch die Belichtungseigenschaften der lichtempfindlichen Mehrschichtenmaterialien werden durch den Zusatz der pyrogenen Kieselsäure nicht beeinträchtigt.

Als Träger (T) für die erfindungsgemäßen lichtempfindlichen Mehrschichtenmaterialien können die verschiedensten, flexiblen oder starren, dimensionsstabilen Trägermaterialien eingesetzt werden, wie sie als solche bekannt und üblich sind. Besonders geeignet als Träger (T) sind beispielsweise Metallbleche oder -folien, z.B. aus Stahl, Aluminium oder Kupfer, sowie Platten, Filme oder Folien aus Kunststoffen, vorzugsweise Polyestern, wie z.B. Polyethylenterephthalat oder Polybutylenterephthalat. Zur Erzielung einer haftfesten Verankerung der photopolymerisierbaren reliefbildenden Schicht (RS) kann der Träger (T) in an sich bekannter Weise mechanisch, chemisch oder durch Versehen mit einer Haftgrundierung vorbehandelt sein. Auch können zwischen dem Träger (T) und der photopolymerisierbaren reliefbildenden Schicht (RS) eine oder mehrere Haftschichten angeordnet sein. Geeignet sind beispielsweise Haftschichten auf Polyurethanbasis, die z.B. aus Polyetherolen, Polyesterolen, hydroxylgruppenhaltigen Polyacrylaten oder hydroxylgruppenhaltigen Polycarbonaten und aliphatischen, cycloaliphatischen und-/oder aromatischen Di- und Polyisocyanaten als Vernetzer hergestellt werden können.

Die photopolymerisierbare reliefbildende Schicht (RS) der erfindungsgemäßen lichtempfindlichen Aufzeichnungsmaterialien enthält als Bindemittel mindestens ein elastomeres Copolymerisat (a) aus aliphatischen konjugierten Dienen mit 4 bis 6 C-Atomen, Acrylnitril und/oder α-substituierten Acrylnitril-Derivaten sowie gegebenenfalls weiteren Comonomeren, wobei carboxylgruppenhaltige Comonomere ausgenommen sind. Als aliphatische konjugierte Diene kommen insbesondere Butadien, Isopren und 2,3-Dimethylbutadien in Betracht. Als Beispiele für α-substituierte Acrylnitril-Derivate seien Methacrylnitril, Ethylacrylnitril und α-halogensubstituiertes Acrylnitril genannt. Als zusätzliche Comonomeren kommen z.B. Ethylen, Propylen, Styrol sowie insbesondere die Alkylester der Acrylsäure oder Methacrylsäure in Betracht.

Typische elastomere Copolymerisate (a) enthalten mindestens 50 Gew.% der konjugierten Diene, vorzugsweise Butadien, 15 bis 45 Gew.% Acrylnitril und/oder Methacrylnitril sowie bis zu 15 Gew.% an weiteren Comonomeren. Das Molekulargewicht (Zahlenmittel) der elastomeren Copolymerisate (a) liegt erfindungsgemäß im Bereich von 15.000 bis 150.000, vorzugsweise im Bereich von 60.000 bis 120.000. Als elastomere Copolymerisate (a) können in der photopolymerisierbaren lichtempfindlichen Schicht (RS) die bekannten und handelsüblichen Nitrilkautschuke enthalten sein. Die Copolymerisate können allein oder auch in Mischung miteinander eingesetzt werden. Besonders bevorzugt sind die elastomeren Butadien/Acrylnitril-Copolymerisate mit einem Acrylnitril-Gehalt zwischen 20 und 40 Gew.%.

Als weiteren wesentlichen Bestandteil enthält die photopolymerisierbare reliefbildende Schicht (RS) mindestens eine mit dem elastomeren Copolymerisat (a) verträgliche niedermolekulare Verbindung mit mindestens zwei photopolymerisierbaren olefinisch ungesättigten Doppelbindungen. Bei den photopolymerisierbaren niedermolekularen Verbindungen (b) kann es sich um Monomere und/oder Oligomere (mit Molekulargewichten bis zu 5.000, vorzugsweise insbesondere bis zu 3.000) handeln. Bevorzugt sind dabei die di-oder poly-ungesättigten Acryl- und/oder Methacrylsäureester, wie beispielsweise die Di-, Tri- oder Tetra-(meth)-acrylate von Diolen, Triolen oder Tetraolen. Hierzu gehören im einzelnen Ethylenglykoldi-(meth)acrylat, Butandiol-1,4-di-(meth)acrylat, Tetraethylenglykol-di-(meth)acrylat, Hexandiol-di-(meth)acrylat, Diethylenglykol-di-(meth)acrylat, Triethylenglykol-di-(meth)acrylat, Polyethylenglykol-di-(meth)acrylate mit einem Molekulargewicht bis etwa 500, Propandiol-1,2-di-(meth)acrylat, Propandiol-1,3-di-(meth)-acrylat, Neopentylglykol-di-(meth)acrylat, Glycerindi-oder -tri-(meth)acrylat, Trimethylolpropandi- oder -tri-(meth)acrylate sowie die entsprechenden Acrylate oder Methacrylate des Pentaerythrits. Als photopolymerisierbare niedermolekulare Verbindungen (b) sind auch präpolymere Urethanacrylate geeignet, wie sie z.B. durch Umsetzung von Hydroxyalkyl-(meth)acrylaten (z.B. β-Hydroxiethyl-(meth)acrylat, β-Hydroxipropyl-(meth)acrylat), aliphatischen Diolen (z.B. der vorstehend genannten Art) und organischen Diisocyanaten (z.B. Hexamethylendiisocyanat oder Isophorondiisocyanat) hergestellt werden können.

Die bi- oder polyfunktionellen, photopolymerisierbaren niedermolekularen Verbindungen (b) können allein oder in Mischung miteinander oder auch in Mischung mit monofunktionellen niedermolekularen Verbindungen mit nur einer photopolymerisierbaren, olefinisch ungesättigten Doppelbindung eingesetzt werden. In den Mischungen aus bi- oder polyfunktionellen photopolymerisierbaren niedermolekularen Verbindungen und monofunktionellen photopolymerisierbaren niedermolekularen Verbindungen liegt der Anteil der monofunktionellen Verbindungen im allgemeinen im Bereich von 1 bis 5 Gew.%, bezogen auf das Gemisch dieser Verbindungen. Beispiele für vorteilhafte monofunktionelle photopolymerisierbare niedermolekulare Verbindungen sind insbesondere die Monoacrylate und/oder die Monomethacrylate von Monoalkoholen mit 1 bis 8 Kohlenstoffatomen, z.B. Methyl-(meth)acrylat, Ethyl-(meth)acrylat, Butyl-(meth)acrylat, Hexyl-(meth)acrylat, 2-Ethylhexyl-(meth)acrylat, sowie die Monoacrylate und/oder Monomethacrylate von Diolen, Triolen oder anderen höherwertigen Alkoholen, wozu insbesondere die Monoacrylate und Monomethacrylate des Ethylenglykols, des Propandiols-1,2, des Propandiols-1,3, des Butandiols-1,4 oder des Di-, Tri- oder Tetraethylenglykols gehören.

In der photopolymerisierbaren reliefbildenden Schicht (RS) sind erfindungsgemäß 55 bis 95 Gew.%, vorzugsweise 70 bis 90 Gew.%, des elastomeren Copolymerisats (a) sowie 5 bis 45 Gew.%, vorzugsweise 10 bis 30 Gew.%, der photopolymerisierbaren niedermolekularen Verbindungen (b), jeweils bezogen auf die Summe von (a)+(b), enthalten.

Als Photopolymerisationsinitiatoren, die in der photopolymerisierbaren, reliefbildenden Schicht (RS) erfindungsgemäß in Mengen von 0,01 bis 10 Gew.%, vorzugsweise von 0,05 bis 5 Gew.%, bezogen auf die Schicht (RS), enthalten sind, kommen die für photopolymerisierbare Gemische üblichen und an sich bekannten Photoinitiatoren bzw. Initiator-Systeme in Betracht. Hierzu gehören vorzugsweise Acyloine und deren Derivate, wie Benzoin, Benzoinalkylether, -Methylolbenzoin und dessen Ether, -Methylbenzoin und dessen Ether; sowie insbesondere die vicinalen Diketone und deren Derivate, wie z.B. Benzilketale, insbesondere Benzildimethylketal oder Benzilethylenglykolketal. Eine andere Gruppe von besonders vorteilhaften Photopolymerisationsinitiatoren sind die Benzoyl-diphenylphosphinoxide, wie z.B. 2,6-Dimethoxybenzoyl-diphenylphosphinoxid oder 2,4,6-Trimethylbenzoyl-diphenylphosphinoxid. Weitere geeignete und vorteilhafte Acylphosphinoxid-Initiatoren sind beispielsweise in der DE-A-29 09 992 sowie der DE-A-31 14 341 für den Einsatz in photopolymerisierbaren Mischungen beschrieben. Die Photopolymerisationsinitiatoren können auch in Verbindung mit anderen Co-Initiatoren und/oder Aktivatoren, wie sie in der einschlägigen Literatur beschrieben sind, verwendet werden.

Die photopolymerisierbare, reliefbildende Schicht (RS) enthält erfindungsgemäß Hilfs- und/oder Zusatzstoffe (d). Erfindungswesentlich ist dabei ein Gehalt von 1 bis 10 Gew.%, bezogen auf die gesamte photopolymerisierbare, reliefbildende Schicht (RS), an pyrogener Kieselsäure mit einem $SiO_2$-Gehalt größer 90 Gew.% (bezogen auf die pyrogene Kieselsäure), einer Oberfläche nach BET von 50 bis 400 m²/g, vorzugsweise von 120 bis 380 m²/g, sowie einer mittleren Primärteilchengröße von 5 bis 50 nm, vorzugsweise von 7 bis 20 nm. Die Bestimmung der spezifischen Oberfläche nach der BET-Methode (Brunnauer-Emmet-Teller-Methode) erfolgt gemäß DIN 66 131).

Außerdem ist in der photopolymerisierbaren, reliefbildenden Schicht (RS) erfindungsgemäß ein thermischer Polymerisationsinhibitor in einer Menge von, bezogen auf die Schicht (RS), 0,001 bis 2 Gew.-% enthalten, um das Auftreten von Vernetzungsreaktionen bei der Herstellung und Handhabung vor der bildmäßigen Belichtung zu verhindern. Beispiele für thermische Polymerisationsinhibitoren sind Hydrochinon, Hydrochinon-Derivate, 2,6-Di-tert.-butyl-p-kresol, Nitrophenole, N-Nitrosoamine, wie N-Nitrosodiphenylamin oder die Salze, insbesondere die Alkali- und Alumimumsalze, des N-Nitrosocyclohexylhydroxylamins, Nitrobenzole oder auch Thiazinfarbstoffe, z.B. Thioninblau G, Methylenblau B oder Toluidinblau.

Erfindungsgemäß enthält die photopolymerisierbare, reliefbildende Schicht (RS) auch einen oder mehrere mit dem elastomeren Copolymerisat (a) verträgliche Weichmacher. Beispiele für geeignete Weichmacher sind Dialkylphthalate, z.B. Dibutylphthalat, Alkylphosphate, Polyalkylenglykole, wie Polyethylenglykol oder Polypropylenglykol, sowie Ester oder Ether der Polyalkylenglykole. Die Weichmacher sind in der photopolymerisierbaren, reliefbildenden Schicht (RS) erfindungsgemäß in Mengen bis zu 35 Gew.%, vorzugsweise in Mengen von 10 bis 25 Gew.%, bezogen auf die Schicht (RS), enthalten. Ihr Einsatz empfiehlt sich z.B., um die Einfriertemperatur des elastomeren Copolymerisats (a) zu senken, und insbesondere immer dann, wenn die photopolymerisierbare, reliefbildende Schicht (RS) aus einer Schmelzmischung der bestandteile, beispielsweise durch Extrudieren, hergestellt wird.

Darüber hinaus kann die photopolymerisierbare, reliefbildende Schicht (RS) beispielsweise Farbstoffe, Pigmente, Antioxydantien, Antiozonantien, weitere Füllstoffe, Verstärkungsmittel etc. in den für diese Stoffe üblichen und gebräuchlichen Mengen enthalten, sofern hierdurch insbesondere nicht die Transparenz und die Belichtungseigenschaften der lichtempfindlichen Mehrschichtenmaterialien beeinträchtigt werden.

Auf der photopolymerisierbaren, reliefbildenden Schicht (RS) der lichtempfindlichen Mehrschichtenmaterialien ist im allgemeinen vorzugsweise noch eine Deckschicht (D) aufgebracht. Diese Deckschicht (D), die vor allem dem Schutz der photopolymerisierbaren, reliefbildenden Schicht (RS) bei der Lagerung und Handhabung der Mehrschichtenmaterialien dient, kann aus beliebigen Materialien bestehen; sie soll jedoch entweder von der photopolymerisierbaren, reliefbildenden Schicht (RS) abziehbar oder in dem gleichen Lösungsmittel löslich sein, wie es für die Entwicklung der bildmäßig belichteten Schicht (RS) zur Anwendung kommt. Die Deckschicht (D) kann aus einem lichtundurchlässigen Material, beispielsweise silikonbeschichteten Papier etc., bestehen, vorzugsweise ist sie jedoch aus einem transparenten, flexiblen Material, insbesondere einer dünnen Kunststoff-Folie, beispielsweise aus Polystyrol, Polyethylen, Polypropylen oder Polyestern, insbesondere Polyethylenterephthalat. Gleichermaßen kommen beispielsweise auch Folien aus Polyamid oder Ethylen/Vinylacetat-Copolymerisaten in Betracht. Im Fall von transparenten Deckschichten (D) kann die bildmäßige Belichtung der lichtempfindlichen Mehrschichtenmaterialien durch diese Deckschicht (D) hindurch erfolgen, indem das bildtragende Negativ direkt auf diese Deckschicht (D) aufgelegt wird und die Deckschicht (D) nach der Belichtung durch Abziehen oder Ablösen entfernt wird.

Die lichtempfindlichen Mehrschichtenmaterialien können nach den üblichen und an sich bekannten Methoden hergestellt werden. Beispielsweise können Lösungen der die photopolymerisierbare, reliefbildende Schicht (RS) bildenden Bestandteile in einem geeigneten Lösungsmittel auf dem Träger (T) zu der Schicht (RS) nach den üblichen Gieß- bzw. Beschichtungsverfahren gegossen, das Lösungsmittel abgedampft und die Schicht (RS) getrocknet werden. Anschließend kann die Deckschicht (D) aufkaschiert oder auflaminiert werden. Als vorteilhaft hat sich auch ein Verfahren erwiesen, bei dem die Bestandteile der photopolymerisierbaren, reliefbildenden Schicht (RS) in üblichen Knet- oder Mischvorrichtungen homogen vermischt und durch Extrudieren, Pressen oder Kalandrieren zu der Schicht (RS) geformt werden. Diese Schicht wird dann beispielsweise durch Laminieren auf den Träger (T) aufgebracht. Vorteilhafterweise kann dies so erfolgen, daß die Bestandteile der photopolymerisierbaren, reliefbildenden Schicht (RS) in einem Extruder homogen gemischt werden und die Schmelze direkt anschließend zwischen Träger (T) und Deckschicht (D) zu der Schicht (RS) kalandriert wird. Man erhält so in einem Arbeitsgang gleich das lichtempfindliche Mehrschichtermaterial. Die Dicke der photopolymerisierbaren, reliefbildenden Schicht (RS) richtet sich insbesondere nach dem Verwendungszweck der lichtempfindlichen Mehrschichtenmaterialien. Für die Herstellung von Flexodruckplatten liegt sie im allgemeinen im Bereich von etwa 0,5 mm bis etwa 7 mm. Der Träger (T) hat im allgemeinen eine Stärke von 0,05 bis 0,2 mm.

Die erfindungsgemäßen lichtempfindlichen Mehrschichtenmaterialien, die sich durch die äußerst geringe Neigung zum kalten Fluß und Auslaufen der photopolymerisierbaren reliefbildenden Schicht (RS) auszeichnen, eignen sich besonders vorteilhaft zur Herstellung jeder beliebigen Art von Reliefformen, insbesondere aber zur Herstellung von Druckformen für den Flexodruck. Die Mehrschichtenmaterialien lassen sich dabei in bekannter Weise zu den Relief- bzw. Druckformen verarbeiten, indem sie durch ein geeignetes Negativ bildmäßig mit aktinischem Licht belichtet werden, das Reliefbild mit einem geeigneten Lösungsmittel entwickelt und schließlich, gegebenenfalls vor oder nach einer vollflächigen Nachbelichtung, getrocknet wird. Zur bildmäßigen Belichtung sowie zur vollflächigen Nachbelichtung eignen sich die üblichen, aktinische Strahlung im Wellenlängenbereich von vorzugsweise 250 bis 420 nm emittierenden Lichtquellen, wie Kohlebogenlampen, Quecksilberdampflampen, Xenonlampen oder Leuchtstofffrößren. Die Entwicklung der Relief- bzw. Druckformen kann durch Aufsprühen des Entwicklerlösungsmittels oder durch Ausreiben oder Ausbürsten mit dem Entwicklerlösungsmittel erfolgen. Als Entwicklerlösungsmittel eignen sich solche, in denen das elastomere Copolymerisat (a) löslich oder zumindest dispergierbar ist. Als organische Lösungsmittel eignen sich beispielsweise insbesondere die chlorierten Kohlenwasserstoffe ; es können aber auch - je nach Art des eingesetzten elastomeren Copolymerisats (a) - wäßrige oder wäßrig-alkalische Entwicklerlösungsmittel Verwendung finden. Die Trocknung der Relief- bzw. Druckformen erfolgt am zweckmäßigsten durch Aufblasen von Heißluft und/oder Beaufschlagen mit Infrarotstrahlung. Die erhaltenen Druckplatten besitzen ausgezeichnete mechanische Eigenschaften und liefern hervorragende Druckergebnisse.

Die Erfindung wird durch die nachfolgenden Beispiele näher erläutert. Die in den Beispielen und Vergleichsversuchen angegebenen Teile und Prozente beziehen sich, sofern nicht anders vermerkt, auf das Gewicht.

Beispiel 1

48,3 Teile eines Butadien/Acrylnitril-Copolymerisats (Acrylnitril-Gehalt : 30 % ; Mooney-Viskosität ML 4 :40), 5 Teile Hexandioldiacrylat, 5 Teile Hexandioldimethacrylat, 1,2 Teile Benzildimethylketal, 1 Teil einer pyrogenen Kieselsäure ($SiO_2$-Gehalt :> 99,8 % ; Oberfläche nach BET : 380 m$^2$/g ; Primärteilchengröße : 7 nm), 0,5 Teile 2,6-Di-tert.-butyl-p-kresol, 30 Teile Dibutylphthalat sowie 0,006 Teile des Farbstoffs Sudantiefschwarz BB wurden in einem Extruder gemischt. Die aus dem Extruder ausgetragene homogene tiefblaue Schmelze wurde zwischen zwei 125μm dicken Polyesterfolien zu einer photopolymerisierbaren Schicht einer Dicke von 2,84 mm kalandriert. Das so erhaltene Mehrschichtenmaterial wurde in Platten der Größe 750 x 1000 mm geschnitten und in Stapeln zu je 10 Platten gelagert. Nach 4wöchiger Lagerung bei Raumtemperatur war eine leichte Verklebung der Plattenkanten festzustellen, wobei sich die einzelnen Platten jedoch immer noch ohne Probleme voneinander trennen ließen. Anschließend wurden die Platten durch ein photographisches Negativ bildmäßig mit aktinischem Licht belichtet und mit einem Trichlorethylen/Butanol-Gemisch (8 :2) ausgewaschen. Die Platten, die eine sehr gute Transparenz aufwiesen, besaßen dabei einen hohen Belichtungsspielraum von größer als 6 Minuten. Die entwickelten und belichteten Platten wurden für den Flexodruck eingesetzt und lieferten hervorragende Druckergebnisse.

Beispiel 2

Es wurde wie in Beispiel 1 gearbeitet, diesmal wurden jedoch 3 Teile der pyrogenen Kieselsäure verwendet. Eine Beispiel 1 entsprechende, leichte Verklebung der Plattenkanten konnte erst nach 3 Monaten Lagerung bei Raumtemperatur festgestellt werden. Bei Lagerung der Platten bei 50°C war eine leichte Verklebung der Kanten nach etwa 4 Wochen zu beobachten.

Beispiel 3

Es wurde entsprechend wie in Beispiel 1 gearbeitet, die Menge an zugesetzter pyrogener Kieselsäure diesmal jedoch auf 5 Teile erhöht. Selbst nach über 3monatiger Lagerung der gestapelten Platten, sowohl bei Raumtemperatur als auch bei 50°C war keinerlei Verklebung der Plattenkanten festzustellen. Im übrigen zeigten die Platten die gleichen guten anwendungstechnischen Eigenschaften wie die Platten gemäß Beispiel 1.

Vergleichsversuch A

Es wurde wie in Beispiel 3 gearbeitet, zur Herstellung des photopolymerisierbaren Gemisches diesmal jedoch anstelle der pyrogenen Kieselsäure 5 Teile Calciumstearat eingesetzt. Nach 4wöchiger Lagerung der Plattenstapel bei Raumtemperatur war die photopolymerisierbare Schicht so stark ausgeflossen und die Kanten der Platten in einem solchen Maße verklebt, daß die Platten zur Herstellung von Druckformen unbrauchbar waren. Darüberhinaus waren die Platten durch den Zusatz an Calciumstearat so stark getrübt, daß die Belichtungseigenschaften deutlich verschlechtert waren und ein positiver Belichtungsspielraum nicht mehr gegeben war.

Vergleichsversuch B

Es wurde wie in Beispiel 3 gearbeitet, anstelle der pyrogenen Kieselsäure bei der Herstellung des photopolymerisierbaren Gemisches diesmal jedoch 5 Teile einer hochdispersen gefällten Kieselsäure eingesetzt ($SiO_2$-Gehalt: 88 %; BET-Oberfläche: 150 m$^2$/g). Die Platten zeigten starke Trübung; es war kein positiver Belichtungsspielraum gegeben. Nach 3wöchiger Lagerung waren die Platten an den Rändern verklebt.

Vergleichsversuch C

Es wurde wie in Beispiel 3 gearbeitet, anstelle der pyrogenen Kieselsäure diesmal jedoch 5 Teile eines PVC-Pulvers eingesetzt, das in der Schmelze homogen in die Platte eingearbeitet wurde. Die Platten wiesen extrem lange Belichtungszeiten auf. Das Verkleben der Ränder bei Lagerung durch Auslaufen der photopolymerisierbaren Schicht konnte nicht beseitigt werden.

**Patentansprüche**

1. Lichtempfindliches Mehrschichtenmaterial, insbesondere zur Herstellung von flexographischen Druckplatten, mit einer auf einem dimensionsstabilen Träger (T) haftfest aufgebrachten photopolymerisierbaren reliefbildenden Schicht (RS), enthaltend mindestens einen Nitrilkautschuk, mindestens eine mit dem Nitrilkautschuk verträgliche photopolymerisierbare niedermolekulare Verbindung und sonstige Hilfs- und/oder Zusatzstoffe, sowie gegenenfalls mit einer Derk- oder Schutzschicht (D) für die photopolymerisierbare reliefbildende Schicht (RS), wobei die photopolymerisierbare reliefbildende Schicht (RS), bezogen auf die Summe von (a) + (b),

(a) 55 bis 95 Gew.-% eines elastomeren Copolymerisats (Nitrilkautschuk) eines Molekulargewichts von 15.000 bis 150.000 aus, bezogen auf das Copolymerisat, mindestens 50 Gew.-% eines aliphatischen konjugierten Diens mit 4 bis 6 C-Atomen und 15 bis 45 Gew.-% Acrylnitril und-/oder eines α-substituierten Acrylnitril-Derivats, wobei carboxylgruppenhaltige Comonomere ausgenommen sind, und

(b) 5 bis 45 Gew.-% mindestens einer mit dem elastomeren Copolymerisat (a) verträglichen niedermolekularen Verbindung mit mindestens zwei photopolymerisierbaren olefinisch ungesättigten Doppelbindungen oder Mischungen hiervon mit monoolefinisch ungesättigten photopolymerisierbaren niedermolekularen Verbindungen sowie, bezogen auf die photopolymerisierbare reliefbildende Schicht (RS),

(c) 0,01 bis 10 Gew.-% eines Photopolymerisationsinitiators,

(d) 1 bis 10 Gew.-% einer pyrogenen Kieselsäure mit einem $SiO_2$-Gehalt von größer als 90 Gew.-%, bezogen auf die pyrogene Kieselsäure, einer Oberfläche nach BET (Brunauer-Emmet-Teller) von 50 bis 400 m$^2$/g und einer mittleren Primärteilchengröße von 5 bis 50 nm,

0,001 bis 2 Gew.-% mindestens eines thermischen Polymerisationsinhibitors und

bis zu 35 Gew.-% mindestens eines mit dem elastomeren Copolymerisat (a) verträglichen Weichmachers

miteinander kombiniert enthält.

2. Lichtempfindliches Mehrschichtenmaterial nach Anspruch 1, dadurch gekennzeichnet, daß die pyrogene Kieselsäure eine Oberfläche nach BET von 120 bis 380 m$^2$/g hat.

3. Lichtempfindliches Mehrschichtenmaterial nach Anspruch 1 oder 2, dadurch gekennzeichnet, daß die pyrogene Kieselsäure eine Primärteilchengröße von 7 bis 20 nm aufweist.

4. Lichtempfindliches Mehrschichtenmaterial nach einem der Ansprüche 1 bis 3, dadurch gekennzeichnet, daß das elastomere Copolymerisat (a) mindestens 50 Gew.-% Butadien, Isopren und/oder Dimethylbutadien und 15 bis 45 Gew.-% Acrylnitril und/oder Methacrylnitril sowie gegebenenfalls bis zu 15 Gew.-% an weiteren Comonomeren einpolymerisiert enthält.

5. Lichtempfindliches Mehrschichtenmaterial nach Anspruch 4, dadurch gekennzeichnet, daß das elastomere Copolymerisat (a) 50 bis 80 Gew.-% Butadien und 20 bis 40 Gew.-% Acrylnitril einpolymerisiert enthält.

6. Lichtempfindliches Mehrschichtenmaterial nach einem der Ansprüche 1 bis 5, dadurch gekennzeichnet, daß in der photopolmerisierbaren reliefbildenden Schicht (RS) als photopolmerisierbare niedermolekulare Verbindungen (b) Acrylsäureester und/oder Methacrylsäureester enthalten sind.

7. Lichtempfindliches Mehrschichtenmaterial nach einem der Ansprüche 1 bis 6, dadurch gekennzeichnet, daß in der photopolymerisierbaren reliefbildenden Schicht (RS) als Weichmacher (d) Dialkylphthalate, Alkylphosphate, Polyalkylenglykole sowie Ester oder Ether der Polyalkylenglykole enthalten sind.

8. Lichtempfindliches Mehrschichtenmaterial nach einem der Ansprüche 1 bis 7, dadurch gekennzeichnet, daß in der photopolymerisierbaren reliefbildenden Schicht (RS) als thermische Polymerisationsinhibitoren Hydrochinon, Hydrochinon-Derivate, 2,6-Di-tert.-butyl-p-kresol, Nitrophenole, N-Nitrosamine, Alkali- und Aluminiumsalze des N-Nitrosocyclohexylhydroxylamins, Nitrobenzole und/oder Thiazinfarbstoffe enthalten sind.

9. Lichtempfindliches Mehrschichtenmaterial nach einem der Ansprüche 1 bis 8, dadurch gekennzeichnet, daß in der photopolymerisierbaren reliefbildenden Schicht (RS) ferner Farbstoffe, Pigmente, Antioxidantien, Antiozonantien sowie weitere Füllstoffe und/oder Verstärkungsmittel enthalten sind.

## Claims

1. Photosensitive multilayer material, in particular for the production of flexographic printing plates, having a photopolymerizable, relief-forming layer (RL) which is bonded to a dimensionally stable base (B), containing one or more nitrile rubbers, one or more photopolymerizable low molecular weight compounds compatible with the nitrile rubber, and other assistants and/or additives, with or without a cover sheet or protective layer (D) for the photopolymerizable relief-forming layer (RL), wherein the photopolymerizable relief-forming layer (RL) contains, based on the sum of (a) + (b),

(a) from 55 to 95% by weight of an elastomeric copolymer (nitrile rubber) having a molecular weight of from 15,000 to 150,000 and consisting of not less than 50% by weight of an aliphatic conjugated diene of 4 to 6 carbon atoms and from 15 to 45 % by weight of acrylonitrile and/or of an α-substituted acrylonitrile derivative, with the exception of carboxyl-containing comonomers, the percentages being based on the copolymer, and

(b) from 5 to 45% by weight of one or more low molecular weight compounds compatible with the elastomeric copolymer (a) and having two or more photopolymerizable olefinically unsaturated double bonds, or mixtures thereof with monoolefinically unsaturated photopolymerizable low molecular weight compounds, and, based on the photopolymerizable relief-forming layer (RL),

(c) from 0.01 to 10% by weight of a photopolymerization initiator,

(d) from 1 to 10% by weight of a pyrogenic silica having an $SiO_2$ content greater than 90% by weight, based on the pyrogenic silica, a BET (Brunauer-Emmet-Teller) surface area of from 50 to 400 $m^2/g$ and a mean primary particle size of from 5 to 50 nm,

from 0.001 to 2% by weight of one or more thermal polymerization inhibitors and

not more than 35% by weight of one or more plasticizers compatible with the elastomeric copolymer (a),

in combination with one another.

2. Photosensitive multilayer material as claimed in claim 1, wherein the pyrogenic silica has a BET surface area of from 120 to 380 $m^2/g$.

3. Photosensitive multilayer material as claimed in claim 1 or 2, wherein the pyrogenic silica has a primary particle size of from 7 to 20 nm.

4. Photosensitive multilayer material as claimed in any of claims 1 to 3, wherein the elastomeric copolymer (a) contains not less than 50% by weight of butadiene, isoprene and/or dimethylbutadiene and from 15 to 45% by weight of acrylonitrile and/or methacrylonitrile and, if appropriate, up to 15% by weight of further comonomers as copolymerized units.

5. Photosensitive multilayer material as claimed in claim 4, wherein the elastomeric copolymer (a) contains from 50 to 80% by weight of butadiene and from 20 to 40% by weight of acrylonitrile as copolymerized units.

6. Photosensitive multilayer material as claimed in any of claims 1 to 5, wherein acrylates and/or methacrylates are contained in the photopolymerizable, relief-forming layer (RL) as photopolymerizable, low molecular weight compounds (b).

7. Photosensitive multilayer material as claimed in any of claims 1 to 6, wherein dialkyl phthalates, alkyl phosphates, polyalkylene glycols and esters or ethers of polyalkylene glycols are contained in the photopolymerizable, relief-forming layer (RL) as plasticizers (d).

8. Photosensitive multilayer material as claimed in any of claims 1 to 7, wherein hydroquinone, hydroquinone derivatives, 2,6-di-tert-butyl-p-cresol, nitrophenols, N-nitrosamines, alkali metal and aluminum salts of N-nitrosocyclohexylhydroxylamine, nitrobenzenes and/or thiazine dyes are contained in the photopolymerizable, relief-forming layer (RL) as thermal polymerization inhibitors.

9. Photosensitive multilayer material as claimed in any of claims 1 to 8, wherein dyes, pigments, antioxidants, antiozonants and further fillers and/or reinforcing agents are furthermore contained in the photopolymerizable, relief-forming layer (RL).

## Revendications

1. Matériau multicouche sensible à la lumière (a), en particulier pour la fabrication de plaques d'impression flexographiques, à couche formant relief (RS) photopolymérisable, appliquée, solidement adhérente sur un support (T) stable en dimension, contenant au moins un caoutchouc nitrile, au moins un composé à bas poids moléculaire, photopolymérisable, compatible avec le caoutchouc nitrile et divers auxiliaires et additifs, ainsi éventuellement avec une couche de recouvrement ou de protection (D) pour la couche formant relief photopolymérisable (RS), la couche formant relief photopolymérisable (RS) contenant, combinés entre eux, rapportés à la somme de (a) + (b),

a) 55 à 95 % en poids d'un copolymérisat élastomère (caoutchouc nitrile) d'un poids moléculaires de 15 000 à 150 000, de rapportés au copolymérisat, au moins 50 % en poids d'une diène aliphatique ayant 4 à 6 atomes C et 15 à 45 % en poids d'acrylonitrile et/ou un dérivé d'acrylonitrile substitué en α, des comonomères à groupes carboxyle étant exclus, et

b) 5 à 45 % en poids d'au moins d'un composé à bas poids moléculaire, compatible avec le copolymérisat élastomère (a), ayant au moins deux doubles liaisons photopolymérisables insaturés oléfiniquement ou les mélanges de ceux-ci avec des composés à bas poids moléculaire, photopolymérisables, insaturés oléfiniquement, ainsi que, rapportés à la couche formant relief, photopolymérisable (RS),

c) 0,01 à 10 % en poids d'un initiateur de photopolymérisation,

d) 1 à 10 % en poids d'un acide silicique pyrogène d'une teneur en SiO$_2$ supérieure à 90 % en poids rapportée à l'acide silicique pyrogène, d'une surface selon BET (Brunnauer-Emmet-Teller) de 50 à 400 m$^2$/g et d'une teneur moyenne en particules primaires de 5 à 50 nm,

0,001 à 2 % en poids d'au moins un inhibiteur de polymérisation thermique et jusqu'à 35 % en poids d'au moins un plastifiant compatible avec le copolymérisat élastomère (a).

2. Matériau multicouche sensible à la lumière selon la revendication 1, caractérisé par le fait que l'acide silicique pyrogène a une surface selon BET de 120 à 380 m$^2$/g.

3. Matériau multicouche sensible à la lumière selon l'une des revendications 1 ou 2, caractérisé par le fait que l'acide silicique pyrogène possède une grosseur de particules primaires de 7 à 20 nm.

4. Matériau multicouche sensible à la lumière selon l'une des revendications 1 à 3 caractérisé par le fait que le copolymérisat élastomère (a) contient, en polymérisation, au moins 50 % en poids de butadiène, isoprène et/ou diméthylbutadiène, 15 à 45 % en poids d'acrylonitrile et/ou métahcrylonitrile, ainsi qu'éventuellement jusqu'à 15 % en poids d'autres comonomères.

5. Matériau multicouche sensible à la lumière selon la revendication 4, caractérisé par le fait que le copolymérisat élastomère contient, en polymérisation, 50 à 80 % en poids de butadiène, 20 à 40 % en poids d'acrylonitrile.

6. Matériau multicouche sensible à la lumière selon l'une des revendications 1 à 5 caractérisé par le fait que, dans la couche (RS) formant relief, photopolymérisable, sont contenus, comme composés (b) à bas poids moléculaire, photopolymérisables, des esters d'acide acrylique et/ou méthacrylique.

7. Matériau d'enregistrement multicouche sensible à la lumière selon l'une des revendications 1 à 6, caractérisé par le fait que, dans la couche (RS) formant relief, photopolymérisable, sont contenus comme plastifiant (d), des diakylphtalates, alkylphosphates, polyalkyléneglycols, ainsi que les esters ou éthers des polyalkyléneglycols.

8. Matériau d'enregistrement multicouche sensible à la lumière selon l'une des revendications 1 à 7, caractérisé par le fait que, dans la couche (RS) formant relief, photopolymérisable, sont contenus comme inhibiteurs de photopolymérisation , l'hydroquinone, des dérivés d'hydroquinone,2,6-di-test-butyl-p-cretol, nitrophénols, N-Nitrosamines, sels alcalins et d'aluminium de la N - nitroso-cyclo-hexyl-hydroxylamine, nitrobenzènes et/ou colorants de thiazines.

9. Matériau d'enregistrement sensible à la lumière selon l'une des revendications 1 à 8, caractérisé par le fait que, dans la couche (RS) formant relief, photopolymérisable, sont contenus, en outre, des colorants, des pigments, des anti-oxydants, des antiozonants, ainsi que d'autres charges et/ou moyens de renforcement.